# EUROPEAN PATENT APPLICATION

(11) **EP 4 040 516 A1**
(43) Date of publication of application: **10.08.2022**
(21) Application number: 20872053.2
(22) Date of filing: 29.09.2020
(51) Int. Cl.: H01L 33/48, H01S 5/022, G02B 6/12, G02B 6/42

(54) **OPTICAL WAVEGUIDE PACKAGE AND LIGHT EMITTING DEVICE**

(30) Priority: 30.09.2019 JP 2019180925; 25.06.2020 JP 2020110002
(71) Applicant: Kyocera Corporation, Kyoto-shi Kyoto 612-8501 (JP)
(72) Inventor: ITAKURA, Yoshiaki, Kyoto-shi, Kyoto 612-8501 (JP)
(74) Representative: Viering, Jentschura & Partner mbB Patent- und Rechtsanwälte
(86) International application number: PCT/JP2020/037008
(87) International publication number: WO 2021/065948

(57) **Abstract**

An optical waveguide package includes a substrate, a cladding on a first surface of the substrate, and a core in the cladding. The cladding has a recess surrounding an element mount. The recess has an inner wall surface including a plurality of wall surfaces and a corner support surface between adjacent wall surfaces of the plurality of wall surfaces.

## Description

### FIELD

The present disclosure relates to an optical waveguide package and a light-emitting device.

### BACKGROUND

A known technique is described in, for example, Patent Literature 1.

### CITATION LIST

### PATENT LITERATURE

Patent Literature 1: Japanese Unexamined Patent Application Publication No. 61-46911

### BRIEF SUMMARY

An optical waveguide package according to an aspect of the present disclosure includes a substrate having a first surface, a cladding located on the first surface and having a second surface facing the first surface and a third surface opposite to the second surface, and a core located in the cladding and extending in a first direction. The cladding has a recess being open in the third surface. The recess includes an element mount in a plan view of the first surface. The core is connected to the recess. The recess has a plurality of wall surfaces intersecting with the third surface, and a corner support surface between adjacent wall surfaces of the plurality of wall surfaces.

A light-emitting device according to another aspect of the present disclosure includes the above optical waveguide package, a light-emitting element on the element mount, and a lens on an optical path of light to be emitted from the core.

### BRIEF DESCRIPTION OF DRAWINGS

FIG. 1 is an exploded perspective view of a light-emitting device including an optical waveguide package according to an embodiment of the present disclosure.
FIG. 2 is a perspective view of the light-emitting device in FIG. 1 without showing a lid.
FIG. 3 is a cross-sectional view of the light-emitting device taken along section line III-III in FIG. 2.
FIG. 4 is a plan view of the light-emitting device.
FIG. 5 is an enlarged plan view of a light-emitting element and its adjacent area.
FIG. 6A is a diagram describing a process for forming a recess.
FIG. 6B is a diagram describing a process for forming a recess.
FIG. 6C is a diagram describing a process for forming a recess.
FIG. 6D is a diagram describing a process for forming a recess.
FIG. 6E is a diagram describing a process for forming a recess.
FIG. 7 is an enlarged plan view of a light-emitting element and its adjacent area.
FIG. 8 is a plan view of a light-emitting device according to another embodiment of the present disclosure.
FIG. 9 is a plan view of a light-emitting device according to still another embodiment of the present disclosure.
FIG. 10 is a plan view of a light-emitting device according to still another embodiment of the present disclosure.
FIG. 11 is a plan view of a light-emitting device according to still another embodiment of the present disclosure.
FIG. 12 is a plan view of a light-emitting device according to still another embodiment of the present disclosure.
FIG. 13 is a plan view of a light-emitting device according to still another embodiment of the present disclosure.
FIG. 14 is an exploded perspective view of a light-emitting device according to still another embodiment of the present disclosure.
FIG. 15 is a perspective view of the light-emitting device in FIG. 14 without showing a lid.
FIG. 16 is a cross-sectional view of the light-emitting device taken along section line XVI-XVI in FIG. 14.

### DETAILED DESCRIPTION

An optical waveguide package according to one or more aspects of the present disclosure includes a quartz glass optical waveguide located on a silicon substrate, light-emitting and light-receiving elements optically coupled to different end faces of the optical waveguide and bonded onto the silicon substrate, and an optical fiber connected to another end face of the optical waveguide. A light-emitting device according to one or more aspects of the present disclosure includes an optical waveguide package basically with the above structure.

The optical waveguide, the light-emitting and light-receiving elements, and the optical fiber are positioned to have their optical axes aligned with one another with the light-emitting and light-receiving elements and the optical fiber in contact with the end faces of the optical waveguide. The light-emitting and light-receiving elements and the optical fiber each have a dimension corresponding to the thickness of the optical waveguide and are thus positioned vertically relative to the silicon substrate. The optical waveguide package and the light-emitting device are to include smaller components and allow easier positioning.

In the optical waveguide package and the light-emitting device, the light-emitting and light-receiving elements may thermally expand in use. The thermal expansion may cause misalignment of the optical axis between the optical waveguide, the light-emitting and light-receiving elements, and the optical fiber, or may cause deformation or damage of the light-emitting and light-receiving elements and components in contact with these elements. The optical waveguide package and the light-emitting device are to be designed to accommodate thermal expansion of the light-emitting and light-receiving elements.

An optical waveguide package and a light-emitting device according to one or more embodiments of the present disclosure will now be described with reference to the accompanying drawings.

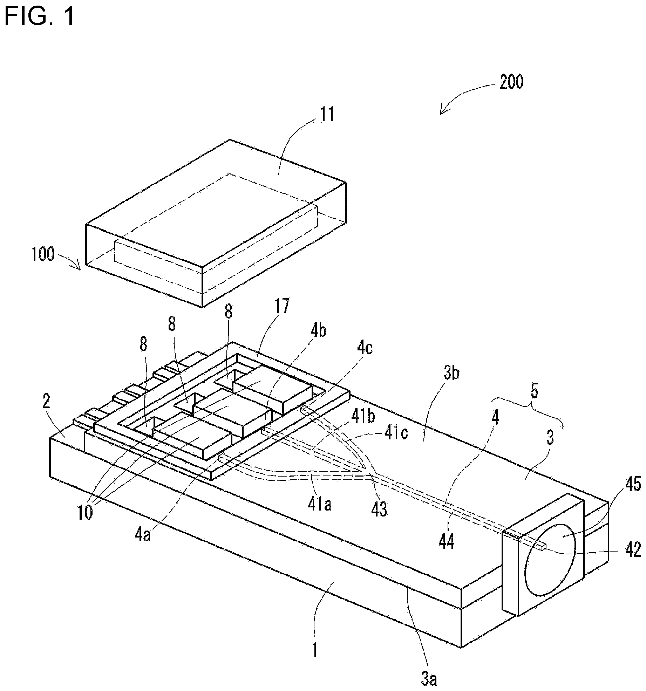

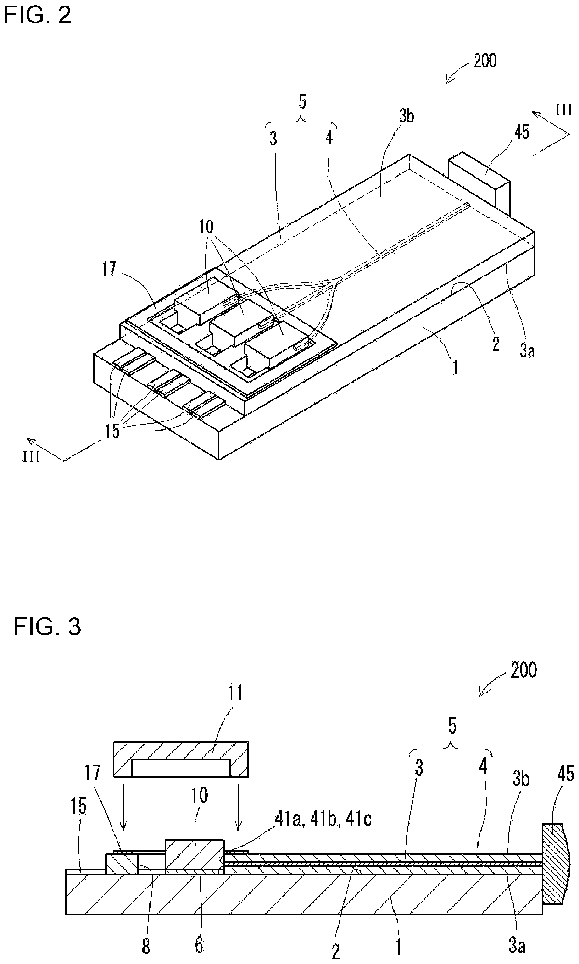

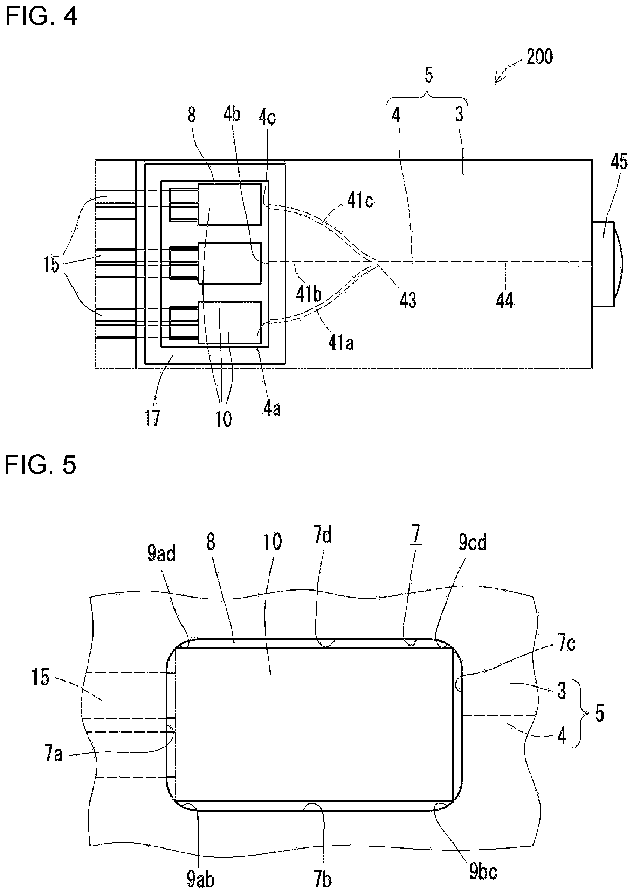

An optical waveguide package 100 according to the present embodiment shown in FIGs. 1 to 5 includes a substrate 1 and an optical waveguide layer 5. The substrate 1 has a first surface 2. The optical waveguide layer 5 is on the first surface (upper surface) 2 of the substrate 1 and includes a cladding 3 and a core 4 in the cladding 3. The cladding 3 is on the first surface 2 of the substrate 1. The cladding 3 has a second surface 3a facing the first surface 2 and a third surface 3b opposite to the second surface 3a. The cladding 3 has recesses 8 that are open in the third surface 3b. Each recess 8 includes an element mount 6 in a plan view of the first surface 2. Each recess 8 has an inner wall surface 7 surrounding the element mount 6. The core 4 in the cladding 3 is connected to the recesses 8 and extends in a first direction. Each recess 8 accommodates an element mount 6. Alid 11 may be placed on the cladding 3 to cover the recesses 8.

The optical waveguide package 100 according to the present embodiment has multiple (three in the present embodiment) recesses 8 each accommodating a light-emitting element 10. The optical waveguide package 100, the light-emitting elements 10, and a lens 45 form a light-emitting device 200. The light-emitting elements 10 may be laser diodes that emit light with respective colors, or red (R) light, green (G) light, and blue (B) light. The optical waveguide layer 5 includes the core 4 and the cladding 3 integral with each other. The substrate 1 may include multiple dielectric layers stacked on one another.

The substrate 1 may be a ceramic wiring board including dielectric layers formed from a ceramic material. Examples of the ceramic material used for the ceramic wiring board include sintered aluminum oxide, sintered mullite, sintered silicon carbide, sintered aluminum nitride, and sintered glass ceramic. For the substrate 1 being a ceramic wiring board, the dielectric layers include conductors such as connection pads, internal wiring conductors, and external connection terminals for electrical connection between the light-emitting elements 10 and light-receiving elements and an external circuit.

The substrate 1 may be an organic wiring board including dielectric layers formed from an organic material. The organic wiring board may be a printed wiring board, a build-up wiring board, or a flexible wiring board. Examples of the organic material used for the organic wiring board include an epoxy resin, a polyimide resin, a polyester resin, an acrylic resin, a phenolic resin, and a fluororesin.

The optical waveguide layer 5 may be glass such as quartz, or a resin. In the optical waveguide layer 5, both the core 4 and the cladding 3 may be glass or a resin. In this case, the core 4 has a higher refractive index than the cladding 3. The difference in the refractive index causes total internal reflection of light. More specifically, a material with a higher refractive index is used to form a path, which is then surrounded by a material with a lower refractive index. This structure confines light in the core 4 with the higher refractive index.

The core 4 has multiple incident end faces 4a, 4b, and 4c and one emission end face 42. The core 4 includes multiple branching paths 41a, 41b, and 41c, a merging portion 43, and a joined path 44 between the incident end faces 4a, 4b, and 4c and the emission end face 42. The branching paths 41a, 41b, and 41c respectively have the incident end faces 4a, 4b, and 4c at one end. The merging portion 43 merges the branching paths 41a, 41b, and 41c together. The joined path 44 has the emission end face 42 at one end.

Red (R) light, green (G) light, and blue (B) light emitted from the respective light-emitting elements 10 enter the respective branching paths 41a, 41b, and 41c through the incident end faces 4a, 4b, and 4c and pass through the merging portion 43 and the joined path 44 and are emitted. The lens 45 is located on the optical path of light emitted from the core 4 and may collimate or condense the light from the core 4.

The lens 45 is, for example, a plano-convex lens with a flat incident surface and a convex emission surface. The optical waveguide layer 5, the light-emitting elements 10, and the lens 45 are assembled together to have the branching paths 41a, 41b, and 41c each with its optical axis aligned with the center of the light emitter of the corresponding light-emitting element 10.

Each recess 8 has the inner wall surface 7 including multiple wall surfaces 7a, 7b, 7c, and 7d and corner support surfaces 9ab, 9bc, 9cd, and 9ad. The wall surfaces 7a, 7b, 7c, and 7d intersect with the third surface. The corner support surfaces 9ab, 9bc, 9cd, and 9ad are each located between a first wall surface and a second wall surface of the wall surfaces 7a, 7b, 7c, and 7d adjacent to each other. The corner support surfaces 9ab, 9bc, 9cd, and 9ad are curved. Each recess 8 has the corner support surfaces 9ab, 9bc, 9cd, and 9ad each located between the first wall surface 7a, 7b, 7c, or 7d and the second wall surface 7a, 7b, 7c, or 7d. The corner support surfaces 9ab, 9bc, 9cd, and 9ad can thus be in contact with and support the four lower corners of a light-emitting element 10. The optical waveguide package 100 with this structure reduces misalignment of the light-emitting elements 10. This structure also allows a small contact area between the light-emitting elements 10 and the cladding 3 and reduces damage to the cladding 3 from thermal expansion. The optical waveguide package 100 thus allows efficient optical coupling between the core 4 and light from the light-emitting elements 10.

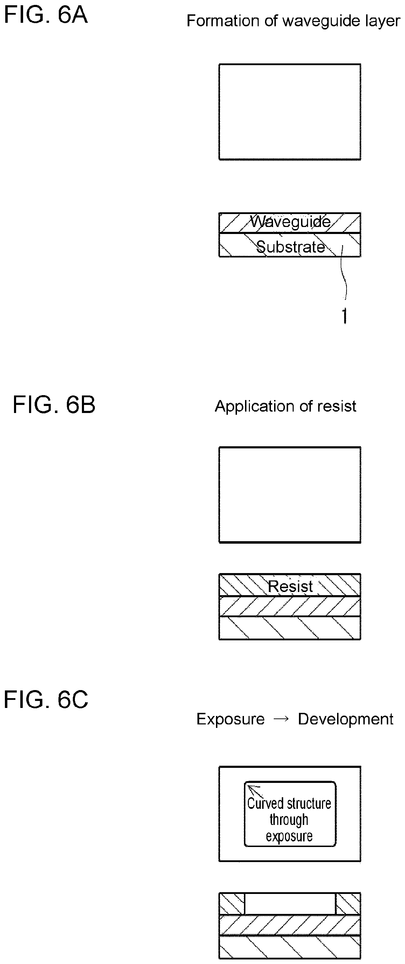

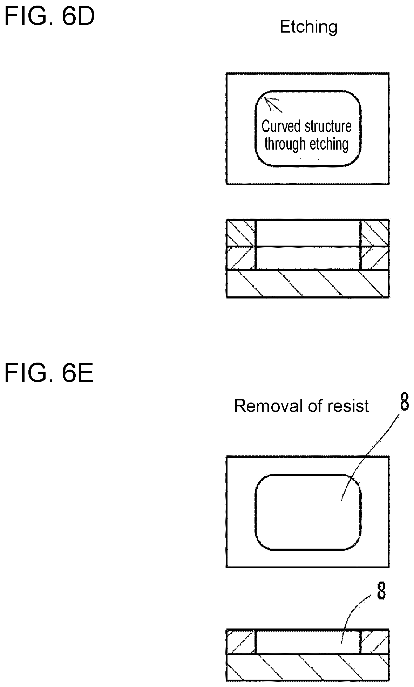

FIGs. 6A to 6E are diagrams describing a process for forming a recess 8. FIGs. 6A to 6E each include, in its upper part, a plan view of an area for one recess 8. FIGs. 6A to 6E each include, in its lower part, a cross-sectional view corresponding to the upper part. As shown in FIG. 6A, a film is deposited on the upper surface 2 of the substrate 1 to form the optical waveguide layer 5. As shown in FIG. 6B, a resist is applied onto the formed optical waveguide layer 5. As shown in FIG. 6C, the applied resist is exposed to light and developed. As shown in FIG. 6D, the optical waveguide layer 5 is etched to form a space to accommodate a light-emitting element 10. As shown in FIG. 6E, the resist is removed to form a recess 8. The recess 8 in an embodiment of the present disclosure extends from the third surface 3b through to the second surface 3a. However, the recess 8 may have any other structure.

When a photomask with a rectangular pattern is used, the recess 8 can be formed to have the curved corner support surfaces 9ab, 9bc, 9cd, and 9ad through photolithography with a predetermined exposure resolution and erosion by etching.

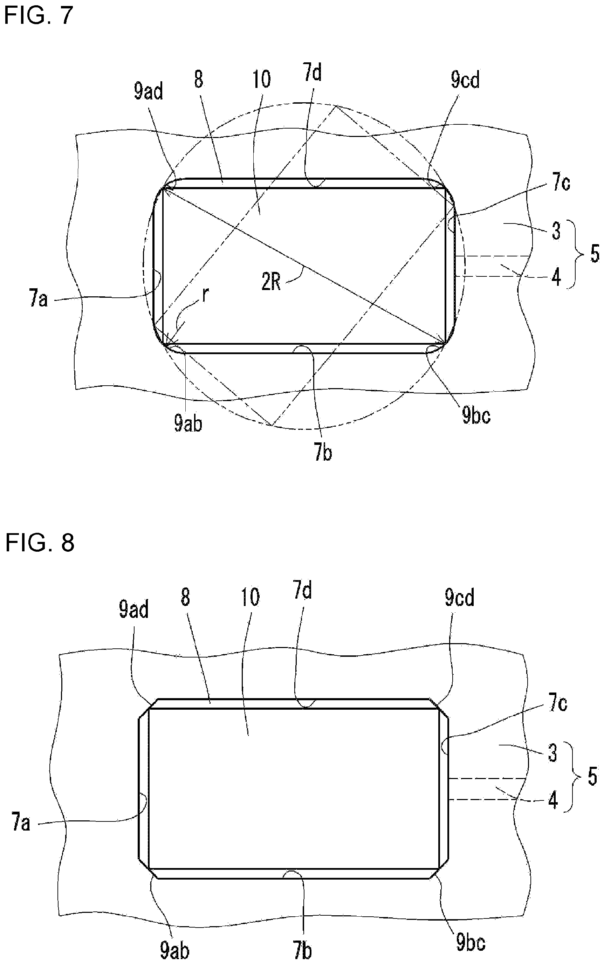

FIG. 7 is an enlarged plan view of a light-emitting element and its adj acent area. An arc of a circle circumscribed on a light-emitting element 10, or in other words, a circle with its diameter as a diagonal 2R of a light-emitting element 10, is imaginarily defined. The corner support surfaces 9ab, 9bc, 9cd, and 9ad may each have a curvature radius r smaller than R to allow accurate positioning and supporting of the light-emitting element 10 without being misoriented in each recess 8. With a smaller curvature radius r, the distance between the optical waveguide layer 5 and the light-emitting element 10 is shorter. The optical waveguide package 100 with the above structure can thus allow efficient optical coupling and downsize each recess 8.

The lid 11 may be located on the third surface 3b of the cladding 3 to cover the recesses 8. The lid 11 and the cladding 3 have a seal ring 17 (second metal member) in between. The seal ring 17 contains a metal material and is, for example, in a continuous loop surrounding the recesses 8. The seal ring 17 improves airtightness in the space accommodating the light-emitting elements 10 (the space defined by the upper surface 2 of the substrate 1, the recesses 8, and the lid 11). The lid 11 may be joined to the cladding 3 with heat. This may cause stress and deform the cladding 3 and the core 4, possibly causing misalignment of the optical axis between each light-emitting element 10 and the core 4. The seal ring 17 surrounding the recesses 8 increases the mechanical strength around the recesses 8 and reduces deformation of the cladding 3 and the core 4. The optical waveguide package 100 thus reduces misalignment of the optical axis between each light-emitting element 10 and the core 4.

The lid 11 may be formed from a glass material such as quartz, borosilicate, or sapphire. For example, the seal ring 17 is formed from Ti, Ni, Au, Pt, or Cr, or two or more of these metals, and is fixed on the third surface 3b of the cladding 3 by vapor deposition, sputtering, ion plating, or plating. The lid 11 may be joined to the seal ring 17 by thermal curing or laser welding using a bond, such as Au-Sn or Sn-Ag-Cu solder, a metal nanoparticle paste of Ag or Cu, or a glass paste.

The seal ring 17 may be located on the lid 11, rather than on the cladding 3, in an area facing the cladding 3. In this case, the seal ring 17 may be formed from Ti, Ni, Au, Pt, or Cr, or two or more of these metals, and may be fixed on the lid 11 by vapor deposition, sputtering, ion plating, or plating. The cladding 3 may be joined to the seal ring 17 by thermal curing or laser welding using a bond, such as Au-Sn or Sn-Ag-Cu solder, a metal nanoparticle paste of Ag or Cu, or a glass paste.

The seal ring 17 may be located on both the cladding 3 and the lid 11. In this case, the seal ring 17 on the cladding 3 may be joined to the seal ring 17 on the lid 11 using a bond, such as Au-Sn or Sn-Ag-Cu solder, a metal nanoparticle paste of Ag or Cu, or a glass paste. The seal rings 17 may be joined together by thermal curing or laser welding.

FIG. 8 is a plan view of a light-emitting device according to another embodiment of the present disclosure. The components corresponding to those in the above embodiments are given the same reference numerals and will not be described repeatedly. In the light-emitting device according to the present embodiment, the corner support surfaces 9ab, 9bc, 9cd, and 9ad are flat. The flat corner support surfaces 9ab, 9bc, 9cd, and 9ad can be in line contact with and support the light-emitting element 10, thus reducing misorientation of the light-emitting element 10.

The intersections or boundaries between the corner support surfaces 9ab, 9bc, 9cd, and 9ad and their corresponding wall surfaces 7a, 7b, 7c, and 7d may be curved. The curved intersections or boundaries reduce damage from, for example, cracks in the wall surfaces 7a, 7b, 7c, and 7d under thermal stress. The intersections or boundaries being curved refer to the inner edges being curved at and around the corners in a plan view, and refer to the curved portions extending in the depth direction of the recess 8 to define curved surfaces. With each of the corner support surfaces 9ab, 9bc, 9cd, and 9ad narrower, the distance between the optical waveguide layer 5 and the light-emitting element 10 is shorter. The optical waveguide package 100 with the above structure can thus allow efficient optical coupling and downsize each recess 8.

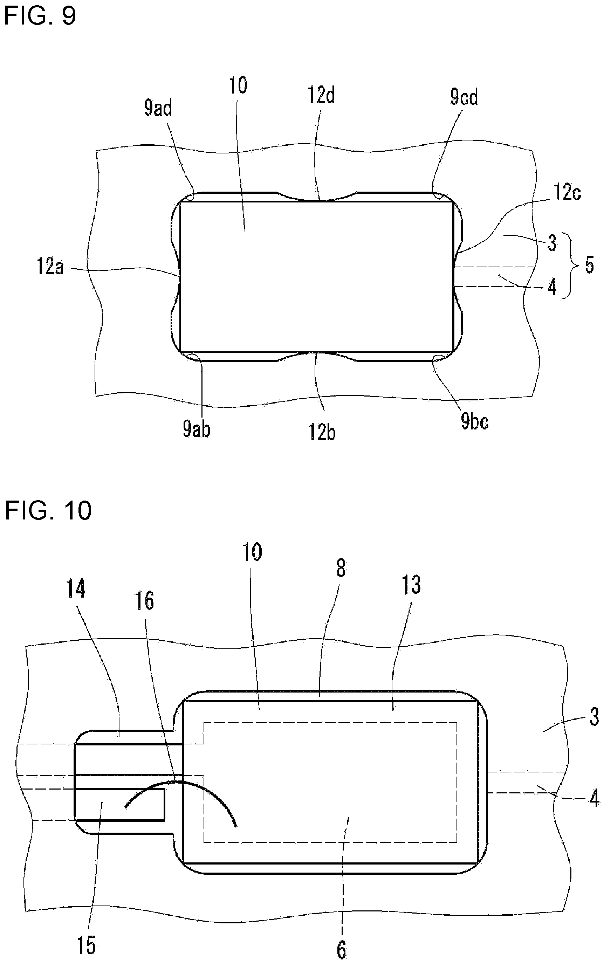

FIG. 9 is a plan view of a light-emitting device according to still another embodiment of the present disclosure. The components corresponding to those in the above embodiments are given the same reference numerals and will not be described repeatedly. In the light-emitting device according to the present embodiment, the wall surfaces 7a, 7b, 7c, and 7d respectively include intermediate support surfaces 12a, 12b, 12c, and 12d protruding toward the center of the recess 8, or in other words, toward the side surfaces of the light-emitting element 10 accommodated in the recess 8.

The wall surfaces 7a, 7b, 7c, and 7d respectively include the intermediate support surfaces 12a, 12b, 12c, and 12d protruding from their sides other than the corner support surfaces 9ab, 9bc, 9cd, and 9ad to have the intermediate support surfaces 12a, 12b, 12c, and 12d in contact with the light-emitting element 10. The wall surfaces 7a, 7b, 7c, and 7d thus have larger areas in line contact with the light-emitting element 10 and can support the light-emitting element 10 more stably. This reduces misalignment of the light-emitting element 10 mounted in the optical waveguide package 100. The intermediate support surface 12a, 12b, 12c, or 12d may protrude to the degree that allows the core 4 facing the emission portion of the light-emitting element 10 to be closer to or in contact with the emission surface of the light-emitting element 10. The optical waveguide package 100 thus allows efficient optical coupling.

FIG. 10 is a plan view of a light-emitting device according to still another embodiment of the present disclosure. The components corresponding to those in the above embodiments are given the same reference numerals and will not be described repeatedly. In the light-emitting device according to the present embodiment, each recess 8 includes a first space 13 to accommodate a light-emitting element 10 and a second space 14 continuous with the first space 13. The second spaces 14 are additional spaces protruding from the first spaces 13 and connected to the wall surfaces 7a, 7b, 7c, or 7d other than the corner support surfaces 9ab, 9bc, 9cd, and 9ad. The second spaces 14 can accommodate electrodes 15 (first metal members) for power supply while the light-emitting elements 10 are supported. The electrodes 15 extend from the element mounts 6 and are located between the first surface 2 of the substrate 1 and the second surface 3a of the cladding 3. The electrodes 15 are located in the first spaces 13 and the second spaces 14 at one end, and located in the external space at the other end. The electrodes 15 thus allows electrical connection to, for example, an external power circuit while maintaining the airtightness in the first spaces 13 and the second spaces 14. Each electrode 15 may include, for example, two parallel wiring strips. One of the wiring strips may have one end connected to an electrode on the upper surface of the corresponding light-emitting element 10 with a metal wiring member 16, such as a bonding wire, for electrical connection. The other wiring strip may have one end connected to the corresponding element mount 6, through which the other wiring strip is electrically connected to an electrode on the lower surface of the corresponding light-emitting element 10.

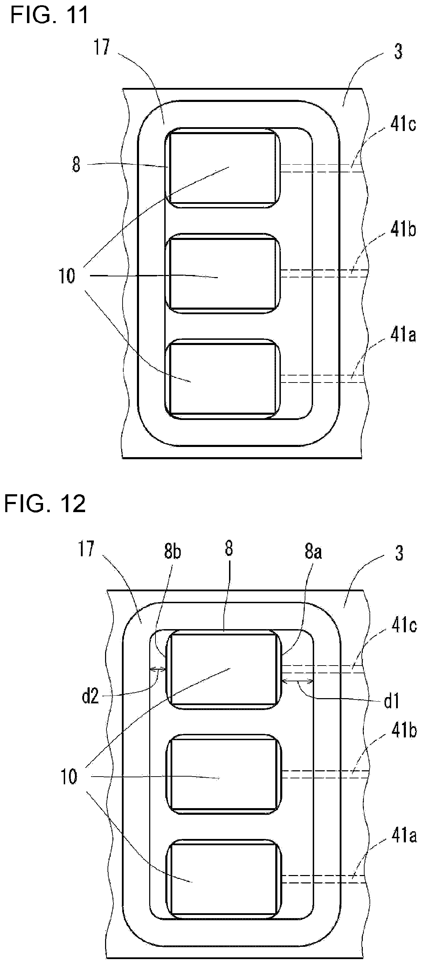

FIG. 11 is a plan view of a light-emitting device according to still another embodiment of the present disclosure. The components corresponding to those in the above embodiments are given the same reference numerals and will not be described repeatedly. In the light-emitting device according to the present embodiment, the recesses 8 have edges spaced from the seal ring 17 in a plan view. The seal ring 17 is exposed to heat for joining the lid 11. The recesses 8 and the seal ring 17 spaced from each other allow a larger space between the heated portions of the cladding 3 and the recesses 8, thus reducing deformation of the cladding 3 and the core 4 under thermal stress. The optical waveguide package 100 thus reduces misalignment of the optical axis between each light-emitting element 10 and the core 4.

FIG. 12 is a plan view of a light-emitting device according to still another embodiment of the present disclosure. The components corresponding to those in the above embodiments are given the same reference numerals and will not be described repeatedly. Each recess 8 has a substantially rectangular opening and has a first side 8a nearest the core 4 and a second side 8b opposite to the first side 8a in a plan view. In the light-emitting device according to the present embodiment, each recess 8 has the first side 8a spaced from the seal ring 17 by a distance d1 longer than a distance d2 between the second side 8b and the seal ring 17. The cladding 3 has a larger space between the heated seal ring 17 and the recesses 8 adjacent to the core 4 to further reduce misalignment of the optical axis between each light-emitting element 10 and the core 4. The optical waveguide package 100 with this structure reduces misalignment of the optical axis between each light-emitting element 10 and the core 4.

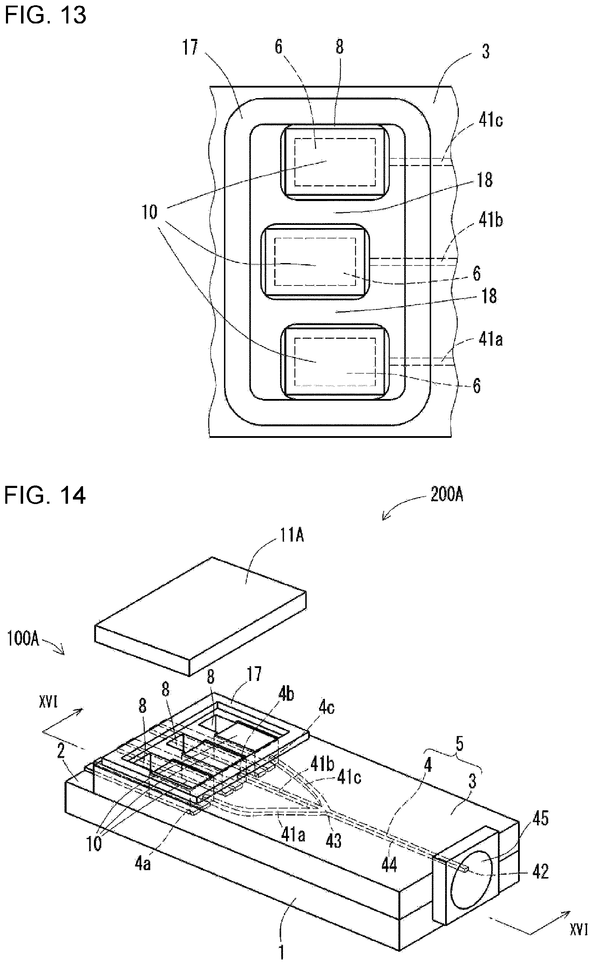

FIG. 13 is a plan view of a light-emitting device according to still another embodiment of the present disclosure. The components corresponding to those in the above embodiments are given the same reference numerals and will not be described repeatedly. In the present embodiment, multiple element mounts 6 are included in a plan view, and partitions 18 are each between adjacent element mounts 6. One recess 8 may include multiple element mounts 6 that receive the respective light-emitting elements 10. To reduce the effects of the light-emitting elements 10 on one another, the partitions 18 defined by the cladding 3 may be included as in the present embodiment. The partitions 18 allow the element mounts 6 to be independent of each other and to be less susceptible to, for example, stray light in the recesses 8. The partitions 18 allow the multiple element mounts 6 to be in the individual recesses 8 having the corner support surfaces 9ab, 9bc, 9cd, and 9ad. The partitions 18 allow distribution of any thermal stress. In the present embodiment, the multiple element mounts 6 are arranged in a second direction intersecting with a first direction along the core 4 in a plan view, with adjacent element mounts 6 out of alignment in a plan view. The element mounts 6 out of alignment in the first direction allow further distribution of the thermal stress and reduce deformation of the cladding 3 and the core 4. The optical waveguide package 100 thus reduces misalignment of the optical axis between each light-emitting element 10 and the core 4.

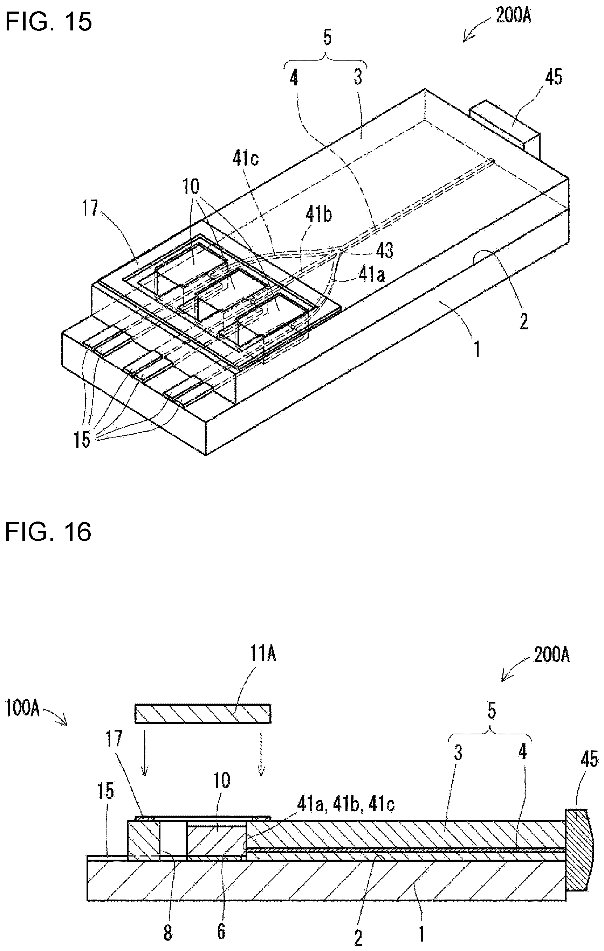

FIG. 14 is an exploded perspective view of a light-emitting device 200A according to still another embodiment of the present disclosure. FIG. 15 is a perspective view of the light-emitting device 200A in FIG. 14 without showing a lid. FIG. 16 is a cross-sectional view of the light-emitting device 200A taken along section line XVI-XVI in FIG. 14. The components corresponding to those in the above embodiments are given the same reference numerals and will not be described repeatedly. In the above embodiments, the light-emitting elements 10 include upper portions protruding from the recesses 8. The protruding portions are covered with the box-shaped lid 11. In another embodiment, the recesses 8 may each accommodate the entire light-emitting element 10 and may be covered and sealed with a platelike lid 11A, as in an optical waveguide package 100A and the light-emitting device 200A including the optical waveguide package 100A according to the present embodiment. This structure simplifies the lid 11A. The structure according to the present embodiment may not allow a space sufficient for connecting the light-emitting elements 10 and the electrodes 15 with the metal wiring members 16. In this case, the light-emitting elements 10 may be flip-chip bonded to the electrodes 15 at their lower surfaces alone to be connected to an external power circuit through the electrodes 15.

In still another embodiment of the present disclosure, the light-emitting elements 10 are not limited to light-emitting diodes (LEDs) but may be, for example, laser diodes (LDs) or vertical cavity surface emitting lasers (VCSELs).

Although embodiments of the present disclosure have been described in detail, the present disclosure is not limited to the embodiments described above, and may be changed or modified in various manners without departing from the spirit and scope of the present disclosure. The components described in the above embodiments may be entirely or partially combined as appropriate unless any contradiction arises.

### Reference Signs List

1 substrate
2 first surface (upper surface)
3 cladding
3a second surface
3b third surface
4 core
4a, 4b, 4c incident end face
5 optical waveguide layer
6 element mount
7 inner wall surface
7a, 7b, 7c, 7d wall surface
8 recess
8a first side
8b second side
9ab, 9bc, 9cd, 9ad corner support surface
10 light-emitting element
11, 11A lid
15 electrode (first metal member)
17 seal ring (second metal member)
18 partition
20 light-emitting device
41a, 41b, 41c branching path
42 emission end face
43 merging portion
44 joined path
45 lens
100, 100A optical waveguide package
200, 200A light-emitting device

## Claims

1. An optical waveguide package, comprising:
a substrate having a first surface;
a cladding on the first surface, the cladding having a second surface facing the first surface and a third surface opposite to the second surface; and
a core located in the cladding and extending in a first direction,
wherein the cladding has a recess being open in the third surface, and the recess includes an element mount in a plan view of the first surface,
the core is connected to the recess, and
the recess has a plurality of wall surfaces intersecting with the third surface, and a corner support surface between adjacent wall surfaces of the plurality of wall surfaces.

2. The optical waveguide package according to claim 1, wherein
the corner support surface is curved.

3. The optical waveguide package according to claim 1, wherein
the corner support surface is flat.

4. The optical waveguide package according to any one of claims 1 to 3, wherein
the plurality of wall surfaces each include an intermediate support surface protruding toward a center of the recess.

5. The optical waveguide package according to any one of claims 1 to 4, wherein
the recess includes a first space including the element mount in the plan view and a second space continuous with the first space.

6. The optical waveguide package according to any one of claims 1 to 5, further comprising:
a first metal member extending from the element mount and located between the first surface and the second surface.

7. The optical waveguide package according to any one of claims 1 to 6, further comprising:
a second metal member located on the third surface and surrounding the recess.

8. The optical waveguide package according to claim 7, wherein
the recess has an edge spaced from the second metal member in the plan view.

9. The optical waveguide package according to claim 7 or claim 8, wherein
the recess has a first side nearest the core and a second side opposite to the first side in the plan view, and
the first side is spaced from the second metal member by a distance longer than a distance between the second side and the second metal member.

10. The optical waveguide package according to any one of claims 1 to 9, wherein
the recess includes a plurality of the element mounts in the plan view and a partition between adjacent element mounts of the plurality of element mounts, and
the plurality of element mounts are arranged in a second direction intersecting with the first direction in the plan view, and the adjacent element mounts are out of alignment in the plan view.

11. A light-emitting device, comprising:
the optical waveguide package according to any one of claims 1 to 10;
a light-emitting element on the element mount; and
a lens on an optical path of light to be emitted from the core.
